# EUROPÄISCHE PATENTSCHRIFT

(11) **EP 3 128 673 B1**
(45) Veröffentlichungstag und Bekanntmachung des Hinweises auf die Patenterteilung: **25.04.2018**
(21) Anmeldenummer: 15401084.7
(22) Anmeldetag: 06.08.2015
(51) Int. Cl.: H01S 3/10, H01S 3/16

(54) **POCKELSZELLEN-TREIBERSCHALTUNG MIT OHMSCHEN, INDUKTIVEN ODER KAPAZITIVEN ELEMENTEN**
POCKELS CELLS DRIVER CIRCUIT WITH OHMIC, INDUCTIVE OR CAPACITIVE ELEMENTS
CIRCUIT D'EXCITATION DE CELLULES POCKELS DOTE D'ELEMENTS OHMIQUES, INDUCTIFS OU CAPACITIFS

(43) Veröffentlichungstag der Anmeldung: 08.02.2017
(73) Patentinhaber: Bergmann Messgeräte Entwicklung KG, 82418 Murnau (DE); Helmholtz-Zentrum Dresden - Rossendorf e.V., 01328 Dresden (DE)
(72) Erfinder: BERGMANN, Thorald Horst, 82418 Murnau (DE); BERGMANN, Fedor, 82418 Murnau (DE); SIEBOLD, Mathias, 01328 Dresden (DE); LÖSER, Markus, 01328 Dresden (DE)
(74) Vertreter: Lambsdorff & Lange Patentanwälte Partnerschaft mbB

(56) Entgegenhaltungen:
- EP-A1- 1 418 460
- WO-A1-2009/103313
- WO-A1-2014/027227
- DE-B3-102007 053 482

## Beschreibung

Die vorliegende Erfindung betrifft eine Treiberschaltung für eine Pockelszelle, eine Pockelszelle mit einer derartigen Treiberschaltung und ein Lasersystem mit einer Pockelszelle und einer derartigen Treiberschaltung.

In Lasersystemen können elektro-optische Modulatoren wie Pockelszellen eingesetzt werden, um Laserpulse zu schalten oder zu selektieren. Eine Pockelszelle - wie z.B. im Dokument EP 1 418 460 A1 beschrieben - kann durch eine geeignete schaltbare Hochspannungsversorgung zwischen zwei Zuständen hin und her geschaltet werden. Die Spannung, welche erforderlich ist, um die jeweils zwei genannten Zustände zu erreichen, ist eine Funktion der Kristallparameter und der verwendeten Wellenlänge des zu schaltenden Lichts.

Bei Experimenten, die im Vorfeld dieser Anmeldung getätigt wurden, hat sich herausgestellt, dass bei standardmäßigem Betrieb einer Pockelszelle mit rechteckförmigem Spannungsverlauf der anfängliche optische Kontrast der Pockelszelle stark abfallen kann. Ein solcher Abfall im optischen Kontrast kann sich nachteilig auf optische Systeme, insbesondere beispielsweise Laserverstärker, auswirken.

Es ist somit Aufgabe der vorliegenden Erfindung eine verbesserte Treiberschaltung für eine Pockelszelle anzugeben, insbesondere eine derartige Treiberschaltung anzugeben, mit welcher die an der Pockelszelle anliegende Spannung manipuliert werden kann. Es ist weiterhin insbesondere Aufgabe der vorliegenden Erfindung, eine Treiberschaltung für eine Pockelszelle anzugeben, mit welcher insbesondere bei mittleren bis längeren Öffnungszeiten der Pockelszelle der optische Kontrast während der Öffnungszeit der Pockelszelle möglichst nahezu konstant gehalten werden kann.

Diese Aufgabe wird mit den Merkmalen der unabhängigen Patentansprüche gelöst. Vorteilhafte Weiterbildungen und Ausgestaltungen sind Gegenstand von Unteransprüchen oder nebengeordneten Ansprüchen.

Die beigefügten Zeichnungen sind vorgesehen, um ein weiteres Verständnis von Ausführungsformen zu gewährleisten und sind in die vorliegende Beschreibung integriert und bilden einen Teil dieser. Die Zeichnungen zeigen Ausführungsformen und dienen zusammen mit der Beschreibung zur Erläuterung von Prinzipien von Ausführungsformen.

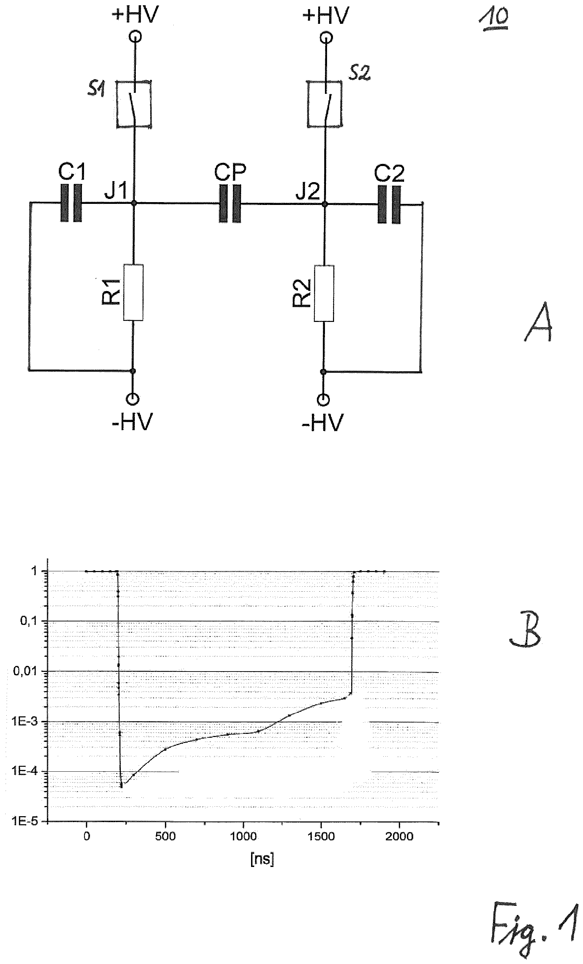

Fig. 1 umfasst Fig. 1A und 1B und zeigt eine schematische Darstellung einer differentiellen Treiberschaltung gemäß einem Ausführungsbeispiel ohne parallel zur Pockelszelle geschaltete Bauelemente (Fig. 1A) und ein gemessenes Kontrast/Zeit-Diagramm einer von der Treiberschaltung angesteuerten Pockelszelle (Fig. 1B).

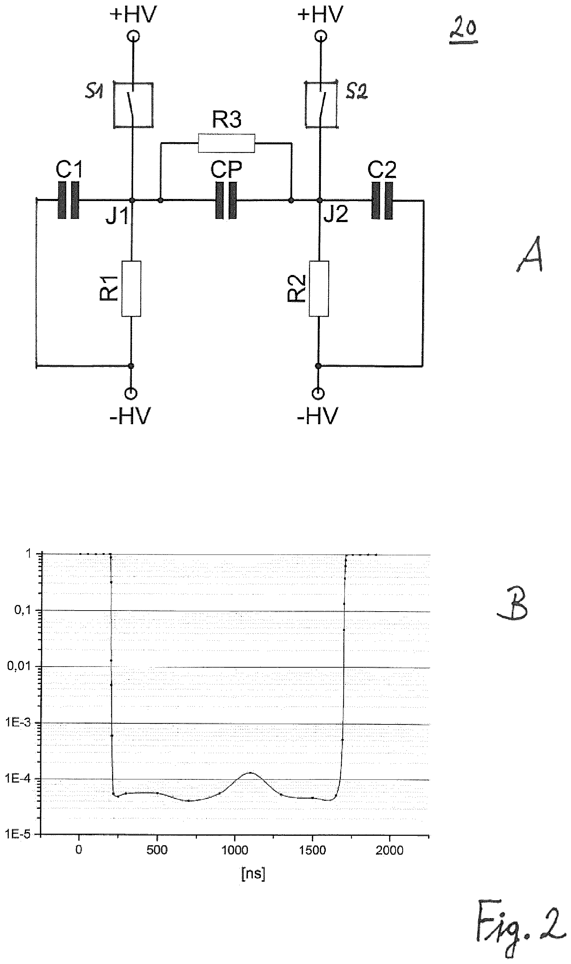

Fig. 2 umfasst Fig. 2A und 2B und zeigt eine schematische Darstellung einer differentiellen Treiberschaltung gemäß einem Ausführungsbeispiel mit einem parallel zur Pockelszelle geschalteten Widerstand (Fig. 2A) und ein gemessenes Kontrast/Zeit-Diagramm einer von der Treiberschaltung angesteuerten Pockelszelle (Fig. 2B).

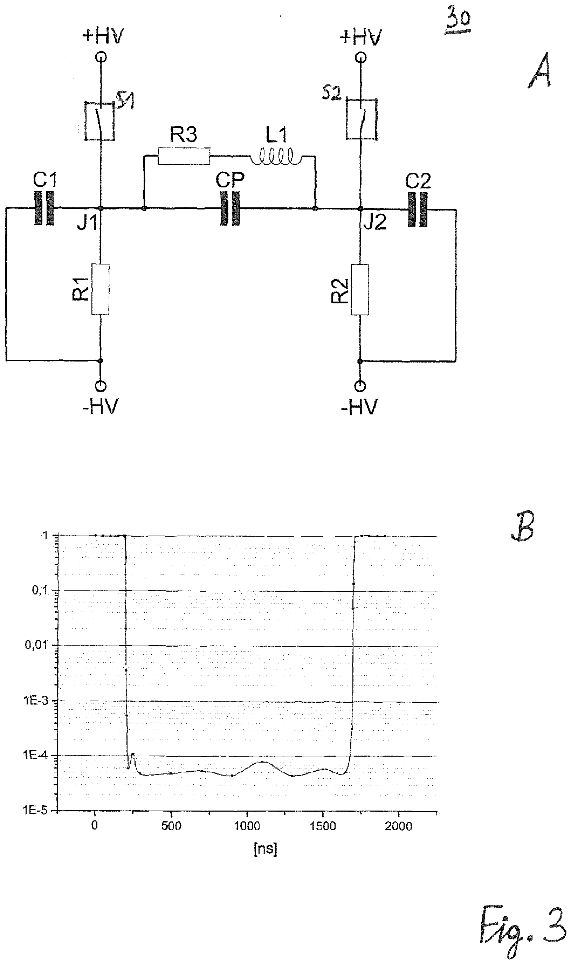

Fig. 3 umfasst Fig. 3A und 3B und zeigt eine schematische Darstellung einer differentiellen Treiberschaltung gemäß einem Ausführungsbeispiel mit einer parallel zur Pockelszelle geschalteten Serienschaltung aus einem Widerstand und einer Induktivität (Fig. 3A) und ein gemessenes Kontrast/Zeit-Diagramm einer von der Treiberschaltung angesteuerten Pockelszelle (Fig. 3B).

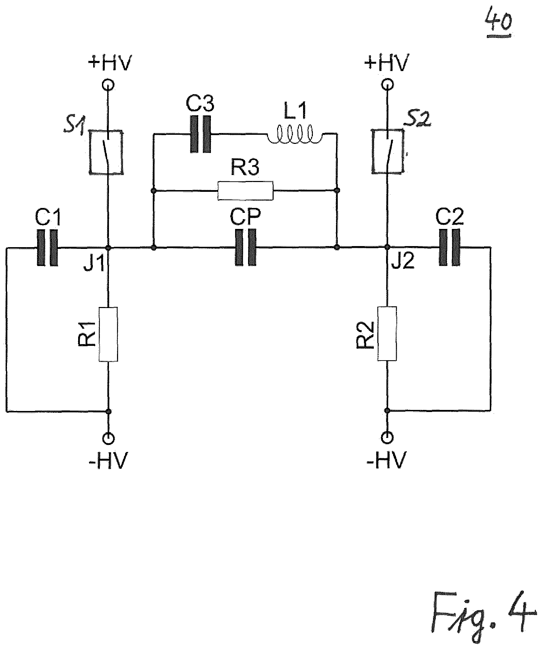

Fig. 4 zeigt eine schematische Darstellung einer beispielhaften differentiellen Treiberschaltung mit einem parallel zur Pockelszelle geschalteten Schwingkreis.

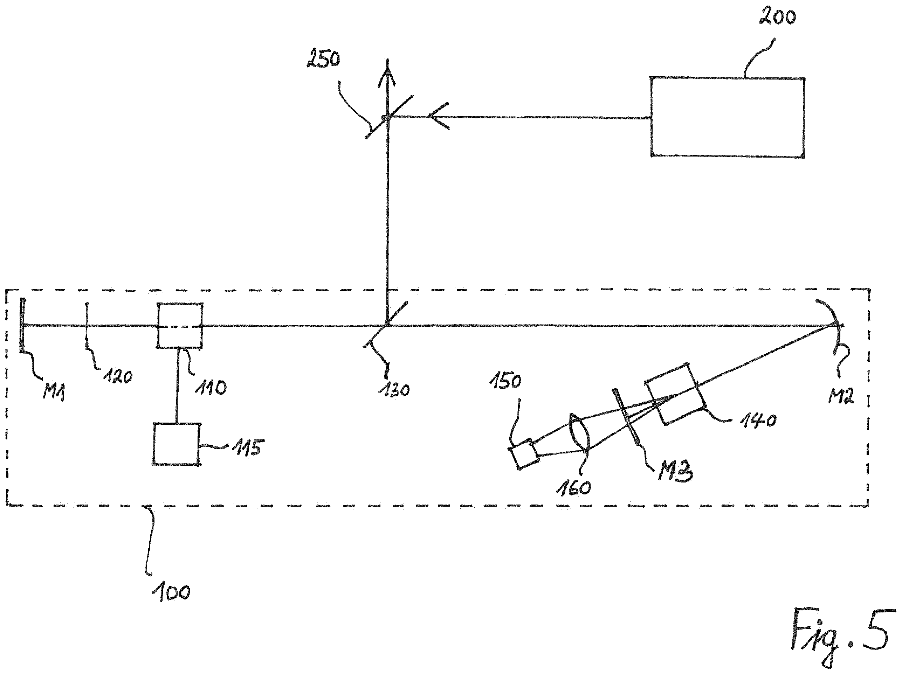

Fig. 5 zeigt eine schematische Darstellung eines Ausführungsbeispiels eines regenerativen Verstärkers mit einer resonatorinternen Pockelszelle, welche von einer differentiellen Treiberschaltung nach einem der vorgenannten Ausführungsbeispiele angesteuert wird.

Insofern in der folgenden Beschreibung, den Patentansprüchen oder den Zeichnungen zum Ausdruck gebracht wird, dass Schaltungselemente miteinander "verbunden", "elektrisch verbunden" oder "elektrisch gekoppelt" sind, so kann dies bedeuten, dass die genannten Elemente direkt, d.h. ohne dazwischen befindliche weitere Elemente miteinander gekoppelt sind. Es kann jedoch auch bedeuten, dass die genannten Elemente nicht direkt miteinander gekoppelt sind und dass weitere Elemente zwischen die genannten Elemente gekoppelt sind. Insofern in den Figuren gleiche Bezugszeichen verwendet werden, so beziehen sich diese auf gleiche oder funktionsgleiche Elemente, so dass in diesen Fällen die Beschreibung dieser Elemente nicht wiederholt wird. Im Rahmen dieser Anmeldung wird der Begriff "Induktivität" auch synonym mit dem Begriff "Induktivitäts-Bauelement" verwendet, der Begriff "Widerstand" wird auch synonym mit dem Begriff "Widerstands-Bauelement" verwendet, und der Begriff "Kondensator" wird auch synonym mit dem Begriff "Kondensator-Bauelement" verwendet und der Begriff "Kapazität" wird auch synonym mit dem Begriff "Kapazitäts-Bauelement" verwendet.

Die vorliegende Anmeldung bezieht sich gemäß einem ersten Aspekt auf eine Treiberschaltung für eine Pockelszelle.

Fig. 1 umfasst Fig. 1A und 1B und Fig. 1A zeigt eine schematische Darstellung eines Ausführungsbeispiels für eine Treiberschaltung für eine Pockelszelle. Die Treiberschaltung 10 enthält einen ersten Knoten J1, welcher mit einem ersten Anschluß einer Pockelszelle CP verbindbar ist, und einen zweiten Knoten J2, welcher mit einem zweiten Anschluß der Pockelszelle CP verbindbar ist. Der erste Knoten J1 ist über eine erste Schalteinheit S1 mit einem ersten Potential +HV verbindbar und der zweite Knoten J2 ist über eine zweite Schalteinheit S2 mit dem ersten Potential +HV verbindbar. Ferner ist der erste Knoten J1 über einen ersten Widerstand R1 mit einem zweiten Potential -HV verbindbar und der zweite Knoten J2 ist über einen zweiten Widerstand R2 mit dem zweiten Potential -HV verbindbar. Die Treiberschaltung weist des Weiteren parasitäre Kapazitäten C1 und C2 auf, welche sich jeweils zwischen den Knoten J1 und J2 und dem zweiten Potential -HV befinden.

Die Ansteuerung dieser Treiberschaltung geschieht derart, dass zunächst beide Schalteinheiten S1 und S2 geöffnet sind. Auf diese Weise ist die Pockelszelle CP spannungslos. Dann wird die Schalteinheit S1 geschlossen, wodurch an der Pockelszelle CP die Spannung +HV anliegt. Wenn anschließend die Schalteinheit S2 geschlossen wird, wird die Pockelszelle CP wieder entladen. Nach einer durch die Anwendung vorgegebenen Wartezeit, beispielsweise 1 µs, werden beide Schalter gleichzeitig geöffnet, womit beide Anschlüsse der Pockelszelle CP mit einer durch R1 und C1 bzw. durch R2 und C2 vorgegebenen Zeitkonstante auf den Wert der anliegenden Hochspannung -HV gezogen werden.

Um den optischen Kontrast der Pockelszelle CP in seiner Zeitabhängigkeit zu untersuchen, wird die Pockelszelle CP zwischen zwei parallele Polarisatoren positioniert. Die Treiberschaltung 10 wurde so betrieben, dass die Öffnungszeit der Pockelszelle CP, also die Zeitspanne zwischen dem Schließen der ersten Schalteinheit S1 und dem Schließen der zweiten Schalteinheit S2, 1,5 µs betrug. Zum Vermessen des optischen Kontrastes der Pockelszelle CP während ihrer Öffnungszeit wurde ein Laserpuls von 8 ns Zeitdauer aus einem regenerativen Verstärker entnommen und damit der Puls der Pockelszelle CP gesampelt. Insbesondere wurde der Laserpuls zeitlich unverändert generiert und relativ zu dem Laserpuls das Schalten der Pockelszelle verzögert. Die entsprechende Zeit auf der X-Achse wurde dann aus der zeitlichen Verzögerung zwischen Laserpuls und Pockelszellenpuls berechnet. Um dann den Kontrast zu bestimmen, wurde mit zwei Fotodioden gearbeitet, von welchen die eine die Leistung des Strahls gemessen hat, der ihr von einem 50%-Strahlteiler vor der Pockelszelle zugeführt wurde. Die andere Fotodiode hat die optische Leistung gemessen, die nach dem Analysator noch vorhanden war.

In Fig. 1B ist das gemessene Kontrast/Zeit-Diagramm dargestellt. Wie man sieht nimmt Kontrast im Verlauf des 1,5 µs langen Pockelszellenpulses von 5 × 10⁻⁵ auf 4 × 10⁻³ ab. Diese Abnahme im Kontrast ist durch die folgenden drei Effekte zu erklären:
1. Die Spannung, welche an der Pockelszelle angelegt wird, ist über längere Zeitspannen nicht konstant. Beim Anlegen der Spannung an den Knoten J1 wird über Kapazitätskopplung auch gleichzeitig das Potential an dem Knoten J2 angehoben. J2 wird allerdings dann über den Widerstand R2 auf ein Potential -HV entladen, was zur Folge hat, dass die Spannung zwischen J1 und J2 größer wird.
2. Die Pockelszelle CP weist einen elektro-optisch aktiven Kristall aus KD*P-Material auf. Dieser Kristall relaxiert auf einer µs-Zeitskala. Er stellt sich also mit zunehmender Zeitdauer auf das angelegte elektrische Feld ein, wodurch der optische Kontrast der Pockelszelle nachläßt.
3. Durch schnelles Anlegen einer Spannung an den Kristall wird eine piezoelektrische Schwingung ausgelöst, welche eine Periode von ca. 10 µs aufweist und mit derselben Periode auch den optischen Kontrast verändert.

Die Fig. 2 umfasst die Fig. 2A und 2B. Fig. 2A zeigt ein Ausführungsbeispiel einer differentiellen Treiberschaltung 20, welche zusätzlich zu der Treiberschaltung 10 der Fig. 1A einen zu der Pockelszelle CP parallel geschalteten dritten Widerstand R3 aufweist. In der Fig. 2B ist das Kontrast/Zeit-Diagramm für diese Treiberschaltung dargestellt. Da die Schaltung in der Zeitspanne von einigen Mikrosekunden linear ist, kann man durch den dritten Widerstand R3 die steigende Spannung an der Pockelszelle ausgleichen, wobei man genau genommen über den dritten Widerstand R3 die Spannung am Anfang und am Ende der Öffnungszeit der Pockelszelle einstellt. Man kann mit dem dritten Widerstand R3 auch teilweise die Relaxation des Kristalls ausgleichen, nicht jedoch die piezoelektrische Schwingung des Kristalls. Die Messkurve zeigt eine maximale relative Abweichung vom mittleren Kontrast von 55%. Bei dieser Messung betrug die parasitäre Kapazität der Pockelszelle CP = 6 pF und der Widerstandswert des dritten Widerstands R3 = 820 kΩ.

Fig. 3 umfasst Fig. 3A und 3B und zeigt in Fig. 3A eine erfindungsgemäße differentielle Treiberschaltung 30, bei welcher der erste Knoten J1 mit dem zweiten Knoten J2 über eine Serienschaltung aus einem dritten Widerstand R3 und einer Induktivität L1 verbunden ist und welche ansonsten wie die Treiberschaltungen 10 und 20 der Fig. 1 und 2 ausgeführt ist. Durch die Hinzufügung der Induktivität L1 kann man nun die Spannung sowohl am Anfang und am Ende als auch in der Mitte des Pulses einstellen. Die Wirkung der Induktivität L1 besteht im Wesentlichen darin, dass das Entladen der Pockelszelle CP nicht mehr linear, sondern exponentiell erfolgt. Im Einzelnen bedeutet dies, dass die Entladung zunächst relativ langsam erfolgt, also ein niedriger Stromfluss stattfindet. Mit zunehmender Dauer wächst der Stromfluss gegen einen Maximalwert und die Entladung wird linear. Abhängig von den Werten der Bauteile stellt sich nach einiger Zeit ein Gleichgewicht ein, welches nur von den Widerständen R1, R2 und R3 abhängt. Die Spannung an der Pockelszelle erreicht einen konstanten Wert von U(CP) = (U0 × R3)/(R2 + R3) (U0 angelegte Spannung).

Es ist zu erwarten, dass die Treiberschaltung 30 der Fig. 3 aufgrund der piezoelektrischen Schwingungen für eine Zeitdauer bis T/4 gute Ergebnisse liefert, wobei T die Periodendauer der Schwingung im Kristall ist (bei KD*P: T = 10 µs). Die in Fig. 3B gezeigte Messung mit dieser Treiberschaltung 30 zeigt, dass hiermit die maximale relative Abweichung vom mittleren Kontrast des Pulses nur mehr 32% beträgt, was einer relativen Verbesserung von 71% gegenüber der Treiberschaltung 20 der Fig. 2 entspricht. Es ist zu erwarten, dass durch genaueres Anpassen der Induktivität L1 und des dritten Widerstands R3 eine noch bessere Kompensation erreicht werden kann. Bei der Messung der Fig. 3B betrug die parasitäre Kapazität der Pockelszelle CP = 6 pF, der Widerstandswert des dritten Widerstands R3 = 400 kΩ und der Induktivitätswert der Induktivität L1 = 9 mH.

Erfindungsgemäß ist die Induktivität L1 durch ein Induktivitäts-Bauelement, insbesondere eine Zylinderspule, gebildet. Es handelt sich dabei insbesondere um ein Induktivitäts-Bauelement, welches für den Betrieb bei Spannungen im kV-Bereich ausgelegt ist.

Gemäß einem Ausführungsbeispiel der Treiberschaltung 30 der Fig. 3 liegt der Widerstandswert des dritten Widerstands R3 in einem Bereich von 100 kΩ - 2000 kΩ.

Gemäß einem Ausführungsbeispiel der Treiberschaltung 30 der Fig. 3 liegt der Induktivitätswert der Induktivität L1 in einem Bereich von 1 mH - 20 mH.

Gemäß einem Ausführungsbeispiel der Treiberschaltung 30 der Fig. 3 sind die beiden Schalteinheiten S1 und S2 bezüglich ihres inneren Aufbaus durch einen einfachen (Hochspannungs-) Transistor oder eine (Hochspannungs-) Transistorkette gegeben.

Gemäß einem Ausführungsbeispiel der Treiberschaltung 30 der Fig. 3 liegt der Widerstandswert des ersten Widerstands R1 in einem Bereich von 100 kΩ - 1000 kΩ.

Gemäß einem Ausführungsbeispiel der Treiberschaltung 30 der Fig. 3 liegt der Widerstandswert des zweiten Widerstands R2 in einem Bereich von 100 kΩ - 1000 kΩ.

Fig. 4 zeigt eine weitere beispielhafte differentielle Treiberschaltung 40, bei welcher der erste Knoten J1 mit dem zweiten Knoten J2 über einen Schwingkreis verbunden ist und welche ansonsten wie die Treiberschaltungen 10 und 20 der Fig. 1 bis 3 ausgeführt ist. Der Schwingkreis weist einen dritten Widerstand R3, eine Kapazität C3 und eine Induktivität L1 auf. Im einzelnen ist der erste Knoten J1 mit dem zweiten Knoten J2 über einen zu der Pockelszelle CP parallel geschalteten dritten Widerstand R3 verbunden, wobei zu diesem noch eine Serienschaltung aus der Kapazität C3 und der Induktivität L1 parallel geschaltet ist.

Die vorliegende Anmeldung bezieht sich gemäß einem zweiten Aspekt auf eine Pockelszelle mit einer Treiberschaltung gemäß dem ersten Aspekt.

Die vorliegende Anmeldung bezieht sich gemäß einem dritten Aspekt auf ein Lasersystem umfassend mindestens eine Pockelszelle gemäß dem zweiten Aspekt.

Die vorliegende Anmeldung bezieht sich gemäß einem vierten Aspekt auf ein Verfahren zum Betrieb eines Lasersystems gemäß dem dritten Aspekt.

In der Fig. 5 ist ein Ausführungsbeispiel eines regenerativen Verstärkers schematisch dargestellt. Der regenerative Verstärker 100 wird durch die innerhalb der gestrichelten Linie gezeigte Anordnung gebildet und weist einen optischen Resonator auf, welcher zwischen den hochreflektierenden Resonatorendspiegeln M1 und M3 angeordnet ist. Innerhalb des Resonators sind im Strahlengang der umlaufenden Laserpulse eine Pockelszelle 110, eine A/4-Platte 120, eine polarisationsselektive Umlenkeinheit 130, beispielsweise einen Dünnschichtpolarisator, ein Umlenkspiegel M2, und ein Verstärkungsmedium 140 angeordnet. Des Weiteren weist der regenerative Verstärker 100 eine Pumplichtquelle 150, beispielsweise ein Laserdiodenarray, und eine Linse 160 auf, welche außerhalb des Resonators angeordnet sind. Die Pockelszelle 110 ist mit einer Treiberschaltung 115 verbunden, wie sie in einem der Ausführungsbeispiele der Figuren 1 bis 4 beschrieben worden ist.

Die Funktionsweise des regenerativen Verstärkers ist wie folgt. Eine Laserstrahlquelle 200 erzeugt Laserpulse mit definierter Polarisation, Energie, Wellenlänge und Wiederholrate. Die Laserpulse werden durch eine Umlenkeinheit 250, beispielsweise einen Dünnschichtpolarisator, in den Resonator des regenerativen Verstärkers 100 eingekoppelt. In dem Verstärkungsmedium 140 wird mittels der Pumpstrahlung der Pumplichtquelle 150 und der Linse 160 eine Besetzungsinversion erzeugt, durch die die durch das Verstärkungsmedium 140 hindurchtretenden Laserpulse verstärkt werden. In der Folge laufen die Laserpulse durch Reflexionen an den Resonatorendspiegeln M1 und M2 mehrfach im Resonator um und werden bei jedem Durchtritt durch das Verstärkungsmedium 140 verstärkt, bis eine gewünschte Endverstärkung erreicht ist und die Laserpulse aus dem Resonator ausgekoppelt werden.

Die Anzahl der Umläufe der Laserpulse im Resonator wird durch die Öffnungszeit der Pockelszelle 110 bestimmt. Nach Einkopplung des Laserpulses und Durchtritt durch die noch ausgeschaltete Pockelszelle 110 wird der Laserpuls durch den zweifachen Durchtritt durch die λ/4-Platte 120 in seiner Polarisation um 90° gedreht. Nach erstmaligem Durchtritt durch das Verstärkungsmedium 140 wird die Pockelszelle eingeschaltet. Nach zweimaligem Durchtritt durch Pockelszelle 110 und λ/4-Platte 120 ist die Polarisation unverändert, so dass der Laserpuls durch die polarisationsselektive Umlenkeinheit 130 keine Ablenkung erfährt. Solange die Pockelszelle 110 somit im eingeschalteten Zustand bleibt, oszilliert der Laserpuls im Resonator zwischen den Resonatorendspiegeln M1 und M3 hin und her und wird bei jedem Durchlauf durch das Verstärkungsmedium 140 verstärkt. Um den Laserpuls auszukoppeln, wird die Pockelszelle 110 ausgeschaltet, wodurch die Polarisation nach zweimaligem Durchtritt durch die λ/4-Platte 120 um 90° gedreht wird und der Laserpuls von der Umlenkeinheit 130 aus dem Resonator ausgekoppelt wird. Der ausgekoppelte Laserpuls ist dann wiederum so polarisiert, dass er von der polarisationsselektiven Umlenkeinheit 250 durchgelassen wird.

Die gewünschte Anzahl von Pulsumläufen hängt u.a. von den Eigenschaften des Verstärkungsmediums 140, insbesondere der erreichbaren Verstärkung im Zustand der Besetzungsinversion, ab. Das Verstärkungsmedium kann beispielsweise eine bekanntermaßen durch das Material bedingte intrinsisch niedrige Verstärkung aufweisen, wie es beispielsweise für Materialien wie Yb:CaF2 oder Yb:Glas der Fall ist. Das Verstärkungsmedium kann aber ebenso eine intrinsisch hohe Verstärkung aufweisen, wobei jedoch bedingt durch die äußere Beschaffenheit die im Betrieb erreichbare Verstärkung bei einfachem Durchgang durch das Verstärkungsmedium nur relativ niedrige Werte aufweist. Beispielsweise kann im Falle von Yb:YAG - also eigentlich einem high-gain-Material - im Falle einer Ausführung in Form dünner Scheiben der (single pass)Gain nur im Bereich von 1.05 - 1.4 liegen. Des Weiteren kann eine lange Umlaufzeit, z.B. 50 ns für vergleichsweise lange Pulse, auch bei wenigen Umläufen eine lange Öffnungszeit der Pockelszelle erfordern. Sind weiterhin verlustbehaftete Optiken wie Gitter, sättigbare Absorber o.ä. im Resonator vorhanden, kann auch dies entweder alleine oder in Kombination mit den oben genannten Fällen zu einer gewünschten hohen Anzahl an Umläufen führen. Auch kann bei hohen Pulswiederholraten der Gain pro Puls sinken und dies kann dann ebengfalls Anlaß für lange Öffnungszeiten sein.

In allen diesen Fällen ist eine vergleichsweise lange Öffnungszeit der Pockelszelle notwendig oder wünschenswert, um eine gewünschte Endverstärkung erreichen zu können. Das bedeutet, dass die Öffnungszeit der Pockelszelle 110 größer als 100 ns, insbesondere größer als 500 ns, betragen sollte. Die Öffnungszeit kann jedoch auch weit länger sein, etwa bis 10 µs oder darüber, was typischerweise je nach Resonatorlänge einer Anzahl von 200 bis 500 Pulsumläufen im Resonator entspricht. Insbesondere bei derart langen Öffnungszeiten ist es von extremer Bedeutung, dass die Pockelszelle einen über die gesamte Öffnungszeit möglichst konstanten Kontrast aufweist und möglichst minimale resonatorinterne Verluste bzw. maximalen Vorpulskontrast bewirkt, da ein zu geringer Vorpulskontrast gleichbedeutend mit ausgekoppelter Strahlung vor dem eigentlichen Laserpuls ist. Dies kann durch die beschriebenen Ausführungsbeispiele von Treiberschaltungen ermöglicht werden. Mit gleichbleibend hohem Kontrast können zudem auch Nachpulse unterdrückt werden, welche durch weiterhin umlaufende und verstärkte Strahlung infolge eines nicht perfekt ausgekoppelten Hauptpulses entstehen können.

Während die Erfindung bezüglich einer oder mehrerer Implementierungen dargestellt und beschrieben worden ist, können an den dargestellten Beispielen Abänderungen und/oder Modifikationen vorgenommen werden, ohne von dem Gedanken und Schutzbereich der beigefügten Ansprüche abzuweichen. Insbesondere sollen bezüglich der durch die oben beschriebenen Komponenten oder Strukturen durchgeführten verschiedenen Funktionen die zum Beschreiben solcher Komponenten beschriebenen Ausdrücke, sofern nicht etwas anderes angegeben ist, einer beliebigen Komponente oder Struktur entsprechen, die die spezifizierte Funktion der beschriebenen Komponente durchführt (die z.B. funktional äquivalent ist), wenngleich sie nicht strukturell der offenbarten Struktur äquivalent ist, die die Funktion in den hierin dargestellten beispielhaften Implementierungen der Erfindung durchführt.

## Patentansprüche

1. Treiberschaltung für Pockelszelle, mit
einem ersten Knoten (J1), welcher mit einem ersten Anschluß einer Pockelszelle (CP) verbindbar ist;
einem zweiten Knoten (J2), welcher mit einem zweiten Anschluß der Pockelszelle (CP) verbindbar ist; wobei
der erste Knoten (J1) über eine erste Schalteinheit (S1) mit einem ersten Potential (+HV) verbindbar ist und der zweite Knoten (J2) über eine zweite Schalteinheit (S2) mit dem ersten Potential (+HV) verbindbar ist; und wobei der erste Knoten (J1) über einen ersten Widerstand (R1) mit einem zweiten Potential (-HV) verbindbar ist und der zweite Knoten (J2) über einen zweiten Widerstand (R2) mit dem zweiten Potential (-HV) verbindbar ist; **dadurch gekennzeichnet, daß** der erste Knoten (J1) mit dem zweiten Knoten (J2) über eine Serienschaltung aus einem dritten Widerstand (R3) und einem Induktivitätsbauelement (L1) verbunden ist.

2. Treiberschaltung nach Anspruch 1, bei welcher der Widerstandswert des dritten Widerstands (R3) in einem Bereich von 100 kΩ bis 2000 kΩ liegt.

3. Treiberschaltung nach Anspruch 1 oder 2, bei welcher der Induktivitätswert des Induktivitätsbauelements (L1) in einem Bereich von 1 mH bis 20 mH liegt.

4. Treiberschaltung nach einem der vorherigen Ansprüche, bei welcher
der Widerstandswert des ersten Widerstands (R1) in einem Bereich von 100 kΩ - 1000 kΩ liegt.

5. Treiberschaltung nach einem der vorherigen Ansprüche, bei welcher
der Widerstandswert des zweiten Widerstands (R2) in einem Bereich von 100 kΩ - 1000 kΩ liegt.

6. Pockelszelle mit einer Treiberschaltung nach einem der vorhergehenden Ansprüche.

7. Lasersystem, umfassend
mindestens eine Pockelszelle mit einer Treiberschaltung nach einem der vorhergehenden Ansprüche 1 bis 5.

8. Lasersystem nach Anspruch 7, ferner umfassend einen regenerativen Verstärker mit einem Resonator, in dessen Strahlengang ein Verstärkungsmedium und die Pockelszelle angeordnet ist.

9. Lasersystem nach Anspruch 8, bei welchem
das Verstärkungsmedium Yb:CaF2, Yb:Glas, Yb:KGW, Yb:KYW, Yb:CAlGO, Yb:CALYO, Yb:YAG, Ti:Sapphire oder Nd:Glas aufweist.

10. Verfahren zum Betrieb eines Lasersystems nach Anspruch 8 oder 9, bei welchem
die Pockelszelle derart angesteuert wird, dass sie für die im Resonator umlaufenden Laserpulse eine Öffnungszeit von größer als 100 ns, insbesondere größer als 200 ns, insbesondere größer als 300 ns, insbesondere größer als 400 ns, insbesondere größer als 500 ns, bereitstellt.

## Claims

1. Driver circuitry for a Pockels cell, comprising
a first node (J1), which is connectable with a first terminal of a Pockels cell (CP);
a second node (J2), which is connectable with a second terminal of the Pockels cell (CP); wherein
the first node (J1) is connectable with a first potential (+HV) via a first switching unit (S1) and the second node (J2) is connectable with the first potential (+HV) via a second switching unit (S2); and wherein
the first node (J1) is connectable with a second potential
(-HV) via a first resistor (R1) and the second node (J2) is connectable with the second potential (-HV) via a second resistor (R2);
**characterIzed in that**
the first node (J1) is connected with the second node (J2) via a series connection of a third resistor (R3) and an inductivity device (L1).

2. Driver circuitry according to claim 1, in which
the resistivity of the third resistor (R3) lies in a range from 100 kΩ to 2000 kΩ.

3. Driver circuitry according to claim 1 or 2, in which
the inductivity of the inductivity device (L1) lies in a range from 1 mH to 20 mH.

4. Driver circuitry according to one of the preceding claims, in which
the resistivity of the first resistor (R1) lies in a range from 100 kΩ to 1000 kΩ.

5. Driver circuitry according to one of the preceding claims, in which
the resistivity of the second resistor (R2) lies in a range from 100 kΩ to 1000 kΩ.

6. Pockels cell comprising a driver circuitry according to one of the preceding claims.

7. Laser system, comprising
at least one Pockels cell comprising a driver circuitry according to one of the preceding claims 1 to 5.

8. Laser system according to claim 7, further comprising a regenerative amplifier comprising a resonator, in the beam path of which an amplifying medium and the Pockels cell are arranged.

9. Laser system according to claim 8, in which
the amplifying medium comprises Yb:CaF2, Yb:glass, Yb:KGW, Yb:KYW, Yb:CAlGO, Yb:CALYO, Yb:YAG, Ti:sapphire or Nd:glass.

10. A method for operation of a laser system according to claim 8 or 9, in which
the Pockels cell is driven in such a way that it provides an opening time for the laser pulses circulating in the resonator of greater than 100 ns, in particular greater than 200 ns, in particular greater than 300 ns, in particular greater than 400 ns, in particular greater than 500 ns.

## Revendications

1. Circuit d'excitation pour cellules Pockels, comportant un premier noeud (J1), qui peut être relié avec un premier raccord d'une cellule Pockels (CP);
un deuxième noeud (J2), qui peut être relié avec un deuxième raccord de la cellule Pockels (CP); dans lequel le premier noeud (J1) peut être relié par l'intermédiaire d'une première unité de commutation (S1) avec un premier potentiel (+HV) et le deuxième noeud (J2) peut être relié par l'intermédiaire d'une deuxième unité de commutation (S2) avec le premier potentiel (+HV); et dans lequel le premier noeud (J1) peut être relié par l'intermédiaire d'une première résistance (R1) avec un deuxième potentiel (-HV) et le deuxième noeud (J2) peut être relié par l'intermédiaire d'une deuxième résistance (R2) avec le deuxième potentiel (-HV);
**caractérisé en ce que**
le premier noeud (J1) est relié avec le deuxième noeud (J2) par l'intermédiaire d'un circuit en série composé d'une troisième résistance (R3) et d'un composant d'inductivité (L1).

2. Circuit d'excitation selon la revendication 1, dans lequel la valeur de résistance de la troisième résistance (R3) est située dans une plage de 100 kΩ à 2000 kΩ.

3. Circuit d'excitation selon la revendication 1 ou 2, dans lequel la valeur d'inductivité du composant d'inductivité (L1) est compris dans une plage de 1 mH à 20 mH.

4. Circuit d'excitation selon une des revendications précédentes, dans lequel la valeur de résistance de la première résistance (R1) est compris dans une plage de 100 kQ - 1000 kΩ.

5. Circuit d'excitation selon une des revendications précédentes, dans lequel la valeur de résistance de la deuxième résistance (R2) est compris dans une plage de 100 kΩ - 1000 kQ.

6. Cellule Pockels comportant un circuit d'excitation selon une des revendications précédentes.

7. Système laser, comprenant au moins une cellule Pockels avec un circuit d'excitation selon une des revendications précédentes 1 à 5.

8. Système laser selon la revendication 7, comprenant en outre un amplificateur régénératif comportant un résonateur, dans le passage de rayon duquel un milieu d'amplification et la cellule Pockels sont disposés.

9. Système laser selon la revendication 8, dans lequel le milieu d'amplification présente du Yb:CaF2, Yb:verre, Yb:KGW, Yb:KYW, Yb:CAlGO, Yb:CALYO, Yb:YAG, Ti:saphir ou Nd:verre.

10. Procédé de fonctionnement d'un système laser selon la revendication 8 ou 9, dans lequel la cellule Pockels est commandée de telle sorte qu'elle fournisse pour l'impulsion laser circulant dans le résonateur un temps d'ouverture plus grand que 100 ns, notamment plus grand que 200 ns, notamment plus grand que 300 ns, notamment plus grand que 400 ns, notamment plus grand que 500 ns.
